# FASCICULE DE BREVET EUROPEEN

(11) **EP 3 291 307 B1**
(45) Date de publication et mention de la délivrance du brevet: **03.11.2021**
(21) Numéro de dépôt: 17156163.2
(22) Date de dépôt: 15.02.2017
(51) Int. Cl.: H01L 29/78, H01L 27/108, H01L 27/12, H01L 29/40

(54) **POINT MEMOIRE**
SPEICHERELEMENT
MEMORY ELEMENT

(30) Priorité: 31.08.2016 FR 1658063
(43) Date de publication de la demande: 07.03.2018
(73) Titulaire: STMICROELECTRONICS SA, 92120 Montrouge (FR)
(72) Inventeur: EL DIRANI, Hassan, 38100 GRENOBLE (FR); SOLARO, Yohann, SINGAPORE 768120 (SG); FONTENEAU, Pascal, 38570 THEYS (FR)
(74) Mandataire: Cabinet Beaumont

(56) Documents cités:
- EP-A2- 2 584 606
- US-A1- 2007 210 418
- US-A1- 2015 126 002
- JING WAN ET AL: "Progress in Z2-FET 1T-DRAM: Retention time, writing modes, selective array operation, and dual bit storage", SOLID STATE ELECTRONICS., vol. 84, 1 juin 2013 (2013-06-01), pages 147-154, XP055366664, GB ISSN: 0038-1101, DOI: 10.1016/j.sse.2013.02.010

## Description

### Domaine

La présente demande concerne un composant microélectronique utilisé comme point mémoire, et plus particulièrement comme point mémoire adapté à des applications à basse consommation d'énergie électrique. La présente demande concerne également un procédé de commande d'un tel point mémoire.

### Exposé de l'art antérieur

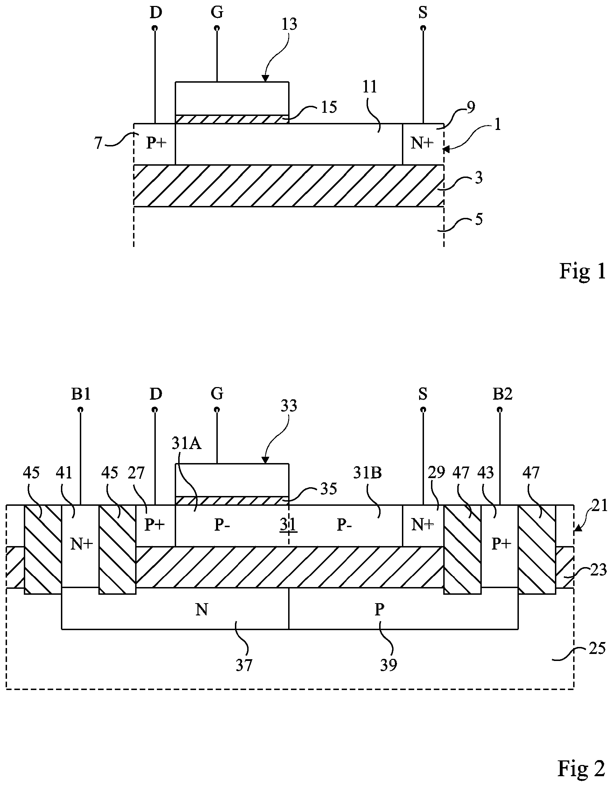

La figure 1 est une vue en coupe représentant schématiquement un point mémoire décrit dans un article de Jing Wan et al. intitulé "Progress in Z2-FET 1T-DRAM: Retention time, writing modes, selective array opération, and dual bit storage" paru en 2013 dans la revue Solid-State Electronics, volume 84, pages 147 à 154.

Le point mémoire comprend une couche de silicium 1 reposant sur une couche isolante 3, elle-même reposant sur un substrat de silicium 5. Une région de drain 7 fortement dopée de type P (P⁺) et une région de source 9 fortement dopée de type N (N⁺) sont disposées dans la couche de silicium 1 et sont séparées l'une de l'autre par une région 11 non dopée de la couche de silicium 1. Du côté de la région de drain 7, le point mémoire comporte une électrode de grille avant isolée 13 (isolant 15) reposant sur une partie seulement de la région 11 de la couche 1. La grille isolée 13, la région de drain 7 et la région de source 9 sont reliées à des noeuds respectifs G, D et S.

En fonctionnement, un potentiel de polarisation négatif de -2 V est appliqué au substrat 5 et un potentiel de référence, la masse, est appliqué au noeud S. Pour lire ou écrire l'une ou l'autre de deux valeurs binaires dans le point mémoire, des potentiels de commande sont appliqués aux noeuds D et G sous la forme d'impulsions. Les valeurs des potentiels de commande et le fonctionnement de ce point mémoire sont décrits plus en détail dans l'article susmentionné.

EP2584606 A2 divulgue une cellule mémoire qui comporte un transistor connecté à un circuit de commande. Le transistor comporte une électrode de grille, une première électrode de source/drain et une deuxième électrode de source/drain. Le transistor est réalisé sur un film semi-conducteur, sur un substrat de type semi-conducteur sur isolant qui comporte un substrat de support, une couche électriquement isolante et le film semi-conducteur. Le substrat comportant une contre-électrode, qui est séparée du film semi-conducteur par la couche électriquement isolante.

### Résumé

Des essais ont montré que le point mémoire de cet article ne fonctionne que si les impulsions de commande appliquées sur la grille avant 13 sont strictement supérieures à 1 V en valeur absolue, ce qui n'est pas compatible avec des applications à basse consommation.

Ainsi, un mode de réalisation prévoit un point mémoire qui pallie certains au moins des inconvénients du point mémoire de la figure 1, et en particulier un point mémoire pouvant fonctionner à faible tension et ayant donc une basse consommation.

Un mode de réalisation prévoit un composant microélectronique comprenant : une couche semiconductrice reposant sur une couche isolante reposant sur un substrat en silicium et comportant une région de source dopée d'un premier type de conductivité, une région de drain dopée d'un deuxième type de conductivité, et une région intermédiaire non dopée ou plus faiblement dopée du deuxième type de conductivité que la région de drain, la région intermédiaire comportant des première et deuxième portions s'étendant respectivement à partir de la région de drain et de la région de source ; une électrode de grille avant isolée reposant sur ladite première portion ; une première électrode de grille arrière disposée sous la couche isolante, en vis-à-vis de la première portion, et comportant une région de silicium dopé du premier type de conductivité ; et une deuxième électrode de grille arrière disposée sous la couche isolante, en vis-à-vis de la deuxième portion, et comportant une région de silicium dopé du deuxième type de conductivité; et des moyens de commande adaptés à fournir un premier potentiel de polarisation à la première électrode de grille arrière, un deuxième potentiel de polarisation, différent du premier potentiel de polarisation, à la deuxième électrode de grille arrière, un potentiel de référence à la région de source, un premier signal de commande à la région de drain et un deuxième signal de commande à l'électrode de grille avant.

Selon un mode de réalisation, la couche semiconductrice est en silicium.

Selon un mode de réalisation, l'épaisseur de la couche semiconductrice est comprise entre 5 et 30 nm, et l'épaisseur de la couche isolante est comprise entre 5 et 30 nm.

Un mode de réalisation prévoit un procédé de commande du point mémoire ci-dessus, dans lequel : pour l'écriture d'un '1', le premier signal de commande est mis du potentiel de référence à un premier niveau de potentiel pendant un premier intervalle temporel, et le deuxième signal de commande est mis d'un deuxième niveau de potentiel au potentiel de référence pendant un deuxième intervalle temporel inclus dans le premier intervalle ; pour l'écriture d'un '0', le deuxième signal de commande est mis du deuxième niveau de potentiel au potentiel de référence pendant un troisième intervalle temporel ; et pour une lecture, le premier signal de commande est mis du potentiel de référence au premier niveau de potentiel pendant un quatrième intervalle temporel, le potentiel de référence étant nul, le premier niveau de potentiel et le deuxième niveau de potentiel étant supérieurs en valeur absolue au potentiel de référence.

Selon un mode de réalisation, pour l'écriture d'un '0', le premier signal de commande est maintenu au potentiel de référence, et, pour la lecture, le deuxième signal de commande est maintenu au deuxième niveau de potentiel.

Selon un mode de réalisation, quand le premier type de conductivité est le type N, le premier niveau de potentiel et le deuxième niveau de potentiel sont positifs, le premier potentiel de polarisation est positif ou nul et le deuxième potentiel de polarisation est négatif ou nul ; et quand le premier type de conductivité est le type P, le premier niveau de potentiel et le deuxième niveau de potentiel sont négatifs, le premier potentiel de polarisation est négatif ou nul et le deuxième potentiel de polarisation est positif ou nul.

Selon un mode de réalisation, le premier niveau de potentiel et le deuxième niveau de potentiel sont inférieurs à 1 V en valeur absolue.

Selon un mode de réalisation, entre deux lectures et/ou écritures successives, le premier signal de commande est maintenu au potentiel de référence et le deuxième signal de commande est maintenu au deuxième niveau de potentiel.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, est une vue en coupe d'un exemple de point mémoire décrit dans l'article de J. Wan *et al*. susmentionné ;
la figure 2 est une vue en coupe représentant schématiquement un mode de réalisation d'un point mémoire ; et
la figure 3 représente des chronogrammes illustrant un mode de réalisation d'un procédé de commande du point mémoire de la figure 2.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés.

Dans la description qui suit, lorsque l'on fait référence à des termes tels que "avant", "arrière", "sur" "sous" "supérieur", "inférieur ", etc., il est fait référence à l'orientation des éléments concernés dans les figures correspondantes. Sauf précision contraire, le terme "sensiblement" signifie à 10 % près, de préférence à 5 % près, et l'expression "reposant sur" signifie "reposant sur et en contact avec".

La figure 2 est une vue en coupe représentant schématiquement un mode de réalisation d'un point mémoire formé dans et sur une structure de type SOI ("Semiconductor On Insulator" - Semiconducteur sur Isolant) comprenant une couche de silicium 21 reposant sur une couche isolante 23 reposant elle-même sur un substrat de silicium 25.

Le point mémoire comprend, dans la couche de silicium 21, une région de drain 27 fortement dopée de type P (P⁺), et une région de source 29 fortement dopée de type N (N⁺). Une portion 31 de la couche de silicium 21, dénommée ci-après région intermédiaire 31, s'étend depuis la région de drain 27 jusqu'à la région de source 29 et sépare les régions 27 et 29 l'une de l'autre. La région intermédiaire 31 est faiblement dopée de type P (P⁻). La région intermédiaire 31 comporte une première portion 31A s'étendant à partir de la région de drain 27, et une deuxième portion 31B s'étendant à partir de la région de source 29. De préférence, les portions 31A et 31B sont en contact l'une avec l'autre. Une électrode de grille avant isolée 33 (isolant 35) repose sur la seule portion 31A de la région 31, sur tout ou partie de cette portion 31A. Deux électrodes de grille arrière 37 et 39 sont disposées dans le substrat 25, sous la couche isolante 23 et en contact avec celle-ci. L'électrode de grille arrière 37 comprend une portion du substrat 25 dopée de type N. L'électrode 37 est disposée en vis-à-vis de la portion 31A de la région intermédiaire 31 et s'étend de préférence sous toute la portion 31A. L'électrode de grille arrière 39 comprend une portion du substrat 25 dopée de type P. L'électrode 39 est disposée en vis-à-vis de la portion 31B de la région 31 et s'étend de préférence sous toute la portion 31B.

La région de drain 27 et l'électrode de grille avant isolée 33 sont connectées à des noeuds respectifs D et G d'application de signaux de commande. La région de source 29, l'électrode de grille arrière 37 et l'électrode de grille arrière 39 sont connectées à des noeuds respectifs S, B1 et B2 d'application de potentiels de polarisation.

Ainsi, deux potentiels de polarisation distincts l'un de l'autre peuvent être appliqués sous la couche isolante 23, en regard de la région intermédiaire 31. Cela diffère du point mémoire de la figure 1 dans lequel un seul potentiel de polarisation est appliqué sous la couche isolante.

Dans le mode de réalisation représenté en figure 2, l'électrode 37 est connectée au noeud B1 par l'intermédiaire d'une région de reprise de contact 41 en silicium fortement dopé de type N (N⁺) et l'électrode 39 est connectée au noeud B2 par une région de reprise de contact 43 en silicium fortement dopé de type P (P⁺). Chacune des régions de reprise de contact 41 et 43 s'étend depuis la face supérieure de la couche de silicium 21 jusqu'à l'électrode 37 ou 39 correspondante. La région 41 est disposée au voisinage de la région de drain 27 et est entourée d'un mur isolant 45. De manière similaire, la région de reprise de contact 43 est disposée au voisinage de la région de source 29 et est entourée d'un mur isolant 47.

A titre d'exemple, les différentes régions, portions et couches décrites ci-dessus ont les dimensions suivantes :
- une épaisseur comprise entre 5 et 30 nm, par exemple 12 nm, pour la couche de silicium 21 ;
- une largeur, prise entre les régions de drain 27 et de source 29, comprise entre 40 nm et 2 µm, par exemple 400 nm, pour la région intermédiaire 31 ;
- une largeur sensiblement égale à la moitié de celle de la région intermédiaire 31, par exemple 200 nm, pour chacune des portions 31A et 31B de la région 31 ; et
- une épaisseur comprise entre 5 et 30 nm, par exemple 20 nm, pour la couche isolante 23.

Pour une filière technologique donnée, les niveaux de dopage peuvent être :
- compris entre 10¹⁷ et 10¹⁹ at.cm⁻³, par exemple 5.10¹⁷ at.cm⁻³, pour les régions dopées de type P ;
- compris entre 10¹⁹ et 10²¹ at.cm⁻³, par exemple 10¹⁹ at.cm⁻³, pour les régions fortement dopées de type P (P⁺) ;
- compris entre 10¹⁴ et 10¹⁶ at.cm⁻³, par exemple 10¹⁵ at.cm⁻³, pour les régions faiblement dopées de type P (P⁻) ;
- compris entre 10¹⁷ et 10¹⁹ at.cm⁻³, par exemple 10¹⁸ at.cm⁻³, pour les régions dopées de type N ; et
- compris entre 10¹⁹ et 10²¹ at.cm⁻³, par exemple 10²⁰ at.cm⁻³, pour les régions fortement dopées de type N (N⁺).

On distingue trois étapes de fonctionnement du point mémoire, à savoir :
- une étape W1 d'écriture d'une première de deux valeurs binaires, par exemple un '1', dans le point mémoire ;
- une étape W0 d'écriture de la deuxième des deux valeurs binaires, par exemple un '0', dans le point mémoire ; et
- une étape de lecture R de la valeur binaire écrite dans le point mémoire. Pour simplifier la description, on distinguera une étape de lecture R réalisée après une étape d'écriture W1 et référencée ci-après R1, d'une étape de lecture R réalisée après une étape d'écriture W0 et référencée ci-après R0, étant entendu qu'en pratique le point mémoire est commandé de la même façon lors de ces étapes R1 et R0.

Entre deux étapes de lecture et/ou d'écriture successives, le point mémoire est à un état de repos ou de maintien.

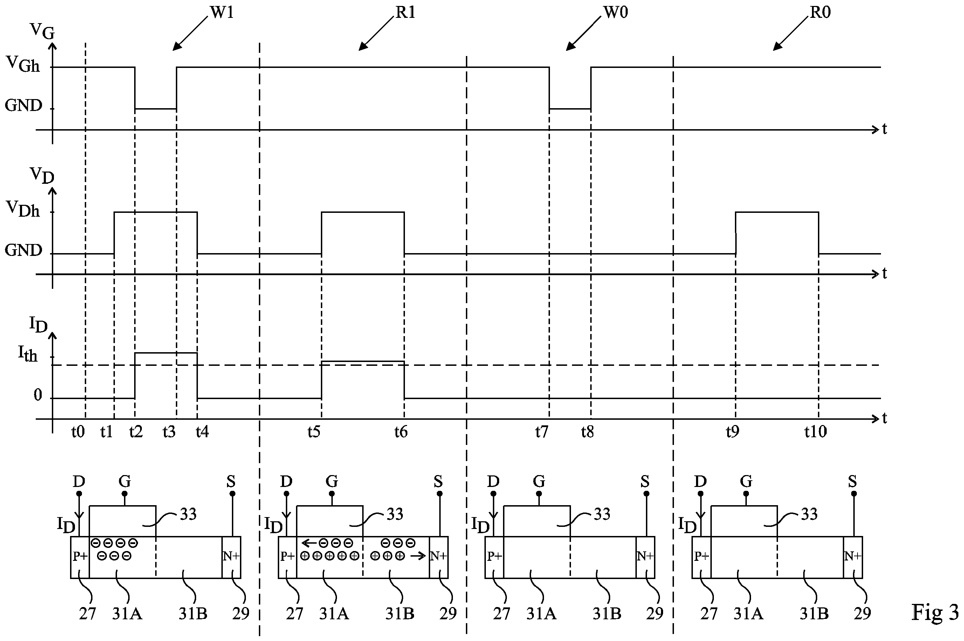

La figure 3 représente, pour des étapes successives W1, R1, W0, R0 séparées les unes des autres par des états de maintien, les chronogrammes du signal de commande V_{G} appliqué au noeud de grille avant G, du signal de commande V_{D} appliqué au noeud de drain D, et du courant I_{D} entrant dans la région de drain 27 depuis le noeud de drain D. L'échelle des abscisses est la même pour V_{G}, V_{D} et I_{D}. Ces chronogrammes sont obtenus pour un point mémoire tel que décrit en relation avec la figure 2. On a également représenté en figure 3, pour chaque étape W1, R1, W0, R0 l'ensemble des régions 27, 29, et 31, et de l'électrode de grille isolée 33 ainsi que les charges électriques dans le point mémoire.

Un potentiel de polarisation négatif pouvant être compris entre 0 et -2 V, par exemple -1 V, est maintenu en permanence sur le noeud B2 et un potentiel de polarisation positif, par exemple 0,5 V, est maintenu en permanence sur le noeud B1. Un potentiel nul de référence GND est maintenu en permanence sur le noeud de source S.

A l'état de maintien, par exemple à un instant initial t0, un niveau de potentiel V_{Gh} supérieur à 0,2 V, par exemple 0,7 V, est maintenu sur le noeud de grille avant G, et le potentiel de référence GND est maintenu sur le noeud de drain D. Du fait de la tension nulle entre les régions de drain 27 et de source 29, aucune charge ne circule entre ces régions 27 et 29 et le courant de drain I_{D} est nul.

Lors d'une étape d'écriture W1, une impulsion de potentiel est appliquée sur le noeud de drain D pendant qu'une impulsion de potentiel est appliquée sur le noeud de grille avant G. Plus particulièrement, un niveau de potentiel V_{Dh} supérieur à 0,2 V, par exemple 0,7 V, est maintenu sur le noeud D entre des instants t1 et t4, et le potentiel de référence GND est maintenu sur le noeud G entre des instants t2 et t3. Entre les instants t1 et t2, du fait de la polarisation des électrodes de grille 33, 37 et 39, la tension entre les régions de drain 27 et de source 29 n'est pas suffisante pour que des charges circulent entre ces régions 27 et 29. Le courant de drain I_{D} est nul. Entre les instants t2 et t3, du fait du passage du signal de commande V_{G} du niveau de potentiel V_{Gh} au niveau de potentiel GND, la tension entre les régions de drain 27 et de source 29 devient suffisante pour que des charges circulent entre ces régions 27 et 29. Le courant I_{D} est alors positif. Entre les instants t3 et t4, bien que le signal de commande V_{G} soit repassé au niveau de potentiel V_{Gh}, le courant I_{D} reste positif et des électrons sont piégés dans la portion 31A, sous l'électrode de grille 33. A partir de l'instant t4, la tension entre les régions 27 et 29 est nulle et le courant I_{D} redevient nul. Comme cela est représenté sous les chronogrammes, après une étape d'écriture W1, des électrons restent piégés, dans la portion 31A, sous l'électrode de grille 33.

Lors d'une étape de lecture R1, une impulsion de potentiel V_{Dh} est appliquée sur le noeud de drain D, entre des instants t5 et t6, alors que le potentiel V_{Gh} est maintenu sur le noeud de grille avant G. Ainsi, entre les instants t5 et t6, les potentiels appliqués au point mémoire sont identiques à ceux appliqués entre les instants t1 et t2. Toutefois, du fait que des électrons sont piégés sous la grille 33, la tension entre les régions de drain 27 et de source 29 est suffisante pour que des charges circulent entre ces régions 27 et 29, comme cela est représenté sous les chronogrammes. Le courant I_{D} alors est positif et le reste tant que le signal de commande V_{D} est maintenu au niveau de potentiel V_{Dh}. Le courant I_{D} est supérieur à une valeur seuil Iₜₕ, par exemple 1 µA, indiquant que l'étape d'écriture précédente correspond à une étape d'écriture W1. On notera que ce courant I_{D} peut être plus faible que pendant l'étape d'écriture W1 du fait que le signal de commande V_{G} est maintenu au niveau de potentiel V_{Gh}.

Pendant une étape d'écriture W0, une impulsion de potentiel GND est appliquée sur le noeud de grille avant G, entre des instants t7 et t8, alors que le potentiel de référence GND est maintenu sur le noeud de drain D. Il en résulte que les électrons piégés sous la grille avant 33 lors d'une étape précédente d'écriture W1 sont évacués vers la région de drain 27. A la fin de l'étape d'écriture W0, il n'y a donc plus d'électrons piégés sous la grille avant 33 comme cela est représenté sous les chronogrammes.

Pendant une étape de lecture R0, une impulsion de potentiel V_{Dh} est appliquée sur le noeud de drain D, entre des instants t9 et t10, alors que le potentiel V_{Gh} est maintenu sur le noeud de grille avant G. Du fait qu'il n'y a pas d'électrons piégés sous la grille 33, la tension entre les noeuds D et S n'est pas suffisante pour entraîner l'établissement d'un courant I_{D} positif contrairement à ce qui a été décrit pour l'étape de lecture R1. Comme cela est représenté sous les chronogrammes, aucune charge ne circule entre les régions 27 et 29 et le courant I_{D} est nul. Le courant I_{D} est inférieur à la valeur seuil Iₜₕ, indiquant que l'étape d'écriture précédente correspond à une étape d'écriture W0.

Dans le point mémoire de la figure 2, le niveau de potentiel V_{Dh} entraînant l'établissement d'un courant I_{D} non nul lors des étapes d'écriture W1 ou de lecture R1 peut avantageusement être choisi inférieur à 1 V. En outre, du fait que la polarisation positive de l'électrode arrière 37 tend à bloquer le passage de charges électriques de la région de drain 27 vers la région 29 à travers la portion 31A de la région intermédiaire 31, le niveau de potentiel V_{Gh} bloquant le passage des charges électriques dans la portion 31A, en particulier lors des étapes de lecture R0, peut avantageusement être choisi inférieur à 1 V. Cela n'est pas possible dans le point mémoire de la figure 1 où le niveau de potentiel appliqué sur la grille 13 doit à lui seul permettre de bloquer le passage de charges électriques de la région de drain vers la région de source alors que la polarisation négative du substrat tend à favoriser le passage de ces charges électriques. De manière avantageuse, les potentiels de polarisation appliqués sur les noeuds B1 et B2 peuvent également être choisis inférieurs à 1 V en valeur absolue.

Le point mémoire décrit ici est plus particulièrement adapté à une utilisation dans une mémoire à rafraîchissement, par exemple une mémoire de type DRAM (de l'anglais "Dynamic Random Acces Memory" - mémoire à accès aléatoire dynamique). En effet, après une étape W0 d'écriture d'un '0', lorsqu'un courant de fuite circule entre les régions de source et de drain, des électrons s'accumulent sous la grille avant 33, d'où il résulte que, après un certain temps, le point mémoire est dans le même état qu'après une étape W1 d'écriture d'un '1'.

A titre d'exemple, les impulsions de potentiel appliquées sur le noeud de grille avant G ont sensiblement la même durée lors d'une étape d'écriture W1 ou W0, cette durée pouvant être comprise entre 1 et 100 ns, par exemple 15 ns. Les impulsions de potentiel appliquées sur le noeud de drain D ont sensiblement la même durée lors d'une étape de lecture R ou d'écriture W1 ou W0, cette durée pouvant être comprise entre 1 et 100 ns, par exemple 20 ns. Les différents niveaux de potentiel des signaux de commande et/ou les potentiels de polarisation décrits ci-dessus peuvent être fournis par un ou plusieurs circuits de commande non décrits. Dans le cas d'une matrice de points mémoire du type de celui de la figure 2, un même circuit de commande peut être commun à plusieurs points mémoire de la matrice, par exemple à tous les points mémoire d'une même ligne.

Des modes de réalisation particuliers ont été décrits. Diverses variantes et modifications apparaîtront à l'homme de l'art.

On a décrit un exemple de fonctionnement du point mémoire de la figure 2 dans le cas où les niveaux de potentiels des signaux de commande sont inférieurs à 1 V en valeur absolue pour une application à basse consommation d'énergie. Les potentiels de polarisation et de commande du point mémoire peuvent être modifiés. En particulier, des niveaux des potentiels de commande supérieurs à 1 V en valeur absolue peuvent être choisis pour commander le point mémoire. Par exemple, on peut prévoir d'adapter les potentiels appliqués au point mémoire pendant son fonctionnement pour le faire passer d'un état nominal à un état à basse consommation, ou l'inverse.

Le procédé de commande décrit en relation avec la figure 3 peut être modifié. Par exemple les impulsions de potentiel appliquées sur le noeud de drain D et sur le noeud de grille avant G peuvent avoir la même durée, et, dans ce cas, ces impulsions seront simultanées lors de l'étape W1 d'écriture d'un '1'. D'autres procédés de commande que celui décrit précédemment peuvent être mis en oeuvre pour écrire et lire le point mémoire de la figure 2. Dans un exemple, qui ne fait pas partie de l'invention, les différents procédés de lecture et d'écriture décrits dans l'article susmentionné de J. Wan et al. pour lire et écrire un point mémoire du type de celui de la figure 1 peuvent être adaptés par l'homme de l'art pour lire et écrire le point mémoire de la figure 2.

On a indiqué précédemment que les première et deuxième valeurs binaires correspondent à un '1' et à un '0'. Ce choix est arbitraire et peut être inversé.

Plusieurs étapes d'écriture peuvent être effectuées avant chaque étape de lecture, et, dans ce cas, la valeur binaire lue pendant l'étape de lecture correspond à la dernière valeur binaire écrite. On peut également prévoir d'effectuer plusieurs étapes de lecture successives entre deux étapes d'écritures.

Les types de conductivité indiqués ci-dessus pour les diverses couches, régions et portions du point mémoire de la figure 2 peuvent tous être inversés en adaptant les potentiels de polarisation et de commande appliqués (les valeurs de potentiels et de courant positives étant alors négatives et inversement).

La couche 21 peut être remplacée par une couche semiconductrice en un matériau autre que du silicium, par exemple en silicium-germanium. La région intermédiaire 31 peut ne pas être dopée.

Les dimensions des différentes couches, régions et portions indiquées ci-dessus à titre d'exemple peuvent être modifiées. Par exemple, on peut prévoir que la portion 31A ait une largeur inférieure à celle de la portion 31B.

Des moyens d'isolation électrique peuvent être prévus, sous la couche isolante 23, entre les deux électrodes de grille arrière 37 et 39, et/ou chacune des électrodes de grille arrière 37 et 39 peut s'étendre sous une partie seulement de la portion 31A ou 31B correspondante. Dans un exemple qui ne fait pas partie de l'invention, et dans le cas où les électrodes de grille arrière 37 et 39 ne sont pas en contact électrique l'une avec l'autre, elles peuvent être réalisées en un autre matériau que du silicium dopé, par exemple en un métal choisi dans le groupe comprenant le cuivre, l'aluminium, le tungstène ou en un alliage de plusieurs métaux de ce groupe.

Les régions de reprise de contact peuvent être remplacées par des vias métalliques s'étendant depuis la surface supérieure de la couche 21 ou depuis la face inférieure du substrat 25 jusqu'à l'électrode arrière correspondante.

Dans un exemple, qui ne fait pas partie de l'invention, le substrat de silicium 25 peut être remplacé par tout autre substrat, par exemple un substrat en verre.

Bien que l'on ait décrit le composant de la figure 2 dans des utilisations en tant que point mémoire, ce composant peut être utilisé dans d'autres applications, qui ne fait pas partie de l'invention. Par exemple ce composant peut être utilisé pour protéger un composant contre des surtensions, par exemple des surtensions provoquées par des décharges électrostatiques (ESD de l'anglais "ElectroStatic Discharge"). Pour cela, le signal de commande V_{G} est fixé en permanence au niveau du potentiel V_{Gh} et le composant à protéger est connecté en parallèle du composant de la figure 2, entre les noeuds D et S. Des essais ont montré que, de manière avantageuse, la différence de tension entre les noeuds de drain D et de source S entraînant le passage d'un courant I_{D} entre les noeuds D et S pour court-circuiter le composant à protéger est plus élevée, en valeur absolue, que chacun des niveaux de potentiels appliqués au composant de la figure 2. Dans un exemple qui ne fait pas partie de l'invention, le composant décrit en relation avec la figure 2 peut également être utilisé comme interrupteur commandé. Dans ce cas, un signal à transmettre, numérique ou analogique, par exemple un signal radiofréquence, est appliqué sur le noeud D. Entre les noeuds D et S, le composant se comporte comme un interrupteur fermé lorsque le signal de commande V_{G} est mis au potentiel V_{Gh}, et comme un interrupteur ouvert lorsque le signal de commande V_{G} est mis au potentiel de référence GND. Des essais ont montré que le passage entre les états fermé et ouvert d'un interrupteur commandé peut être effectué avec des signaux de commande ayant des niveaux de potentiels plus faibles dans le cas où l'interrupteur est réalisé avec le composant de la figure par rapport au cas où l'interrupteur est réalisé avec un thyristor. Cet avantage résulte notamment du fait que, dans le composant de la figure 2, deux potentiels de polarisation différents sont appliqués sous la couche isolante 23, en regard des portions respectives 31A et 31B.

## Revendications

1. Point mémoire comprenant :
un composant microélectronique comprenant :
une couche semiconductrice (21) reposant sur une couche isolante (23) reposant sur un substrat en silicium (25) et comportant une région de source (29) dopée d'un premier type de conductivité, une région de drain (27) dopée d'un deuxième type de conductivité, et une région intermédiaire (31) non dopée ou plus faiblement dopée du deuxième type de conductivité que la région de drain (27), la région intermédiaire (31) comportant des première (31A) et deuxième (31B) portions s'étendant respectivement à partir de la région de drain (27) et de la région de source (29) ; le premier type de conductivité et le deuxième type de conductivité étant opposés
une électrode de grille avant isolée (33) reposant sur ladite première portion (31A) ;
une première électrode de grille arrière (37) disposée sous la couche isolante (23), en vis-à-vis de la première portion (31A), et comportant une région de silicium dopé du premier type de conductivité ; et
une deuxième électrode de grille arrière (39) disposée sous la couche isolante (23), en vis-à-vis de la deuxième portion (31B), et comportant une région de silicium dopé du deuxième type de conductivité ; et
des moyens de commande adaptés à fournir un premier potentiel de polarisation à la première électrode de grille arrière (37), un deuxième potentiel de polarisation, différent du premier potentiel de polarisation, à la deuxième électrode de grille arrière (39), un potentiel de référence (GND) à la région de source (29), un premier signal de commande (V_{D}) à la région de drain (27) et un deuxième signal de commande (V_{G}) à l'électrode de grille avant (33).

2. Point mémoire selon la revendication 1, dans lequel la couche semiconductrice (21) est en silicium.

3. Point mémoire selon la revendication 1 ou 2, dans lequel l'épaisseur de la couche semiconductrice (21) est comprise entre 5 et 30 nm, et l'épaisseur de la couche isolante (23) est comprise entre 5 et 30 nm.

4. Procédé de commande du point mémoire de la revendication 1, dans lequel :
pour l'écriture d'un '1' (W1), le premier signal de commande (V_{D}) est mis du potentiel de référence (GND) à un premier niveau de potentiel (V_{Dh}) pendant un premier intervalle temporel (t1, t4), et le deuxième signal de commande (V_{G}) est mis d'un deuxième niveau de potentiel (V_{Gh}) au potentiel de référence (GND) pendant un deuxième intervalle temporel (t2, t3) inclus dans le premier intervalle ;
pour l'écriture d'un '0' (W0), le deuxième signal de commande (V_{G}) est mis du deuxième niveau de potentiel (V_{Gh}) au potentiel de référence (GND) pendant un troisième intervalle temporel (t7, t8) ; et
pour une lecture (R0, R1), le premier signal de commande (V_{D}) est mis du potentiel de référence (GND) au premier niveau de potentiel (V_{Dh}) pendant un quatrième intervalle temporel (t5, t6 ; t9, t10), le potentiel de référence (GND) étant nul, le premier niveau de potentiel (V_{Dh}) et le deuxième niveau de potentiel (V_{Gh}) étant supérieurs en valeur absolue au potentiel de référence (GND).

5. Procédé de commande selon la revendication 4, dans lequel, pour l'écriture d'un '0' (W0), le premier signal de commande (V_{D}) est maintenu au potentiel de référence (GND), et, pour la lecture (R0, R1), le deuxième signal de commande (V_{G}) est maintenu au deuxième niveau de potentiel (V_{Gh}).

6. Procédé de commande selon la revendication 4 ou 5, dans lequel :
quand le premier type de conductivité est le type N, le premier niveau de potentiel (V_{Dh}) et le deuxième niveau de potentiel (V_{Gh}) sont positifs, le premier potentiel de polarisation est positif ou nul et le deuxième potentiel de polarisation est négatif ou nul ; et
quand le premier type de conductivité est le type P, le premier niveau de potentiel (V_{Dh}) et le deuxième niveau de potentiel (V_{Gh}) sont négatifs, le premier potentiel de polarisation est négatif ou nul et le deuxième potentiel de polarisation est positif ou nul.

7. Procédé de commande selon l'une quelconque des revendications 4 à 6, dans lequel le premier niveau de potentiel (V_{Dh}) et le deuxième niveau de potentiel (V_{Gh}) sont inférieurs à 1 V en valeur absolue.

8. Procédé de commande selon l'une quelconque des revendications 4 à 7, dans lequel, entre deux lectures (R1, R0) et/ou écritures (W1, W0) successives, le premier signal de commande (V_{D}) est maintenu au potentiel de référence (GND) et le deuxième signal de commande (V_{G}) est maintenu au deuxième niveau de potentiel (V_{Gh}).

## Patentansprüche

1. Speicherzelle, die Folgendes aufweist:
ein mikroelektronisches Bauelement, das Folgendes aufweist:
eine Halbleiterschicht (21), die auf einer Isolierschicht (23) liegt, welche auf einem Siliziumsubstrat (25) liegt, und einen dotierten Source-Bereich (29) eines ersten Leitfähigkeitstyps, einen dotierten Drain-Bereich (27) eines zweiten Leitfähigkeitstyps und einen Zwischenbereich (31) aufweist, der nicht oder mit dem zweiten Leitfähigkeitstyp schwächer dotiert ist als der Drain-Bereich (27), wobei der Zwischenbereich (31) einen ersten (31A) und einen zweiten (31B) Abschnitt aufweist, die sich vom Drain-Bereich (27) bzw. vom Source-Bereich (29) aus erstrecken; wobei der erste Leitfähigkeitstyp und der zweite Leitfähigkeitstyp entgegengesetzt sind;
eine isolierte vordere Gate-Elektrode (33), die auf dem ersten Abschnitt (31A) aufliegt;
eine erste hintere Gate-Elektrode (37), die unter der Isolierschicht (23) angeordnet ist, und zwar gegenüber dem ersten Abschnitt (31A), und einen dotierten Siliziumbereich des ersten Leitfähigkeitstyps aufweist;
eine zweite hintere Gate-Elektrode (39), die unter der Isolierschicht (23) angeordnet ist, und zwar gegenüber dem zweiten Abschnitt (31B), und einen dotierten Siliziumbereich des zweiten Leitfähigkeitstyps aufweist; und
Steuermittel, die geeignet sind, eine erste Vorspannung an die erste hintere Gate-Elektrode (37), eine zweite Vorspannung, die sich von der ersten Vorspannung unterscheidet, an die zweite hintere Gate-Elektrode (39), eine Referenzspannung (GND) an den Source-Bereich (29), ein erstes Steuersignal (VD) an den Drain-Bereich (27) und ein zweites Steuersignal (VG) an die vordere Gate-Elektrode (33) zu liefern.

2. Speicherzelle nach Anspruch 1, wobei die Halbleiterschicht (21) aus Silizium besteht.

3. Speicherzelle nach Anspruch 1 oder 2, wobei die Dicke der Halbleiterschicht (21) im Bereich von 5 bis 30 nm liegt, und die Dicke der Isolierschicht (23) im Bereich von 5 bis 30 nm liegt.

4. Verfahren zur Steuerung der Speicherzelle nach Anspruch 1, wobei:
für das Schreiben einer '1' (W1) das erste Steuersignal (V_{D}) für ein erstes Zeitintervall (t1, t4) von der Referenzspannung (GND) auf einen ersten Spannungspegel (V_{Dh}) gesetzt wird, und das zweite Steuersignal (V_{G}) für ein zweites Zeitintervall (t2, t3), das in dem ersten Intervall enthalten ist, von einem zweiten Spannungspegel (V_{Gh}) auf die Referenzspannung (GND) gesetzt wird;
für das Schreiben einer '0' (W0) das zweite Steuersignal (V_{G}) für ein drittes Zeitintervall (t7, t8) von dem zweiten Spannungspegel (V_{Gh}) auf die Referenzspannung (GND) gesetzt wird; und
für ein Auslesen (R0, R1) das erste Steuersignal (V_{D}) für ein viertes Zeitintervall (t5, t6; t9, t10) von der Referenzspannung (GND) auf den ersten Spannungspegel (V_{Dh}) gesetzt wird, wobei die Referenzspannung (GND) Null ist und der erste Spannungspegel (V_{Dh}) und der zweite Spannungspegel (V_{Gh}) im Absolutwert größer als die Referenzspannung (GND) sind.

5. Steuerungsverfahren nach Anspruch 4, wobei für das Schreiben einer '0' (W0) das erste Steuersignal (V_{D}) auf der Referenzspannung (GND) gehalten wird und für das Lesen (R0, R1) das zweite Steuersignal (V_{G}) auf dem zweiten Spannungspegel (V_{Gh}) gehalten wird.

6. Steuerungsverfahren nach Anspruch 4 oder 5, wobei:
wenn der erste Leitfähigkeitstyp vom Typ N ist, der erste Spannungspegel (V_{Dh}) und der zweite Spannungspegel (V_{Gh}) positiv sind, die erste Vorspannung positiv oder Null ist und die zweite Vorspannung negativ oder Null ist; und
wenn der erste Leitfähigkeitstyp vom Typ P ist, der erste Spannungspegel (V_{Dh}) und der zweite Spannungspegel (V_{Gh}) negativ sind, die erste Vorspannung negativ oder null ist und die zweite Vorspannung positiv oder null ist.

7. Steuerungsverfahren nach einem der Ansprüche 4 bis 6, wobei der erste Spannungspegel (V_{Dh}) und der zweite Spannungspegel (V_{Gh}) im Absolutwert kleiner als 1 V sind.

8. Steuerungsverfahren nach einem der Ansprüche 4 bis 7, wobei zwischen zwei aufeinanderfolgenden Lese- (R1, R0) und/oder Schreibvorgängen (W1, W0) das erste Steuersignal (V_{D}) auf der Referenzspannung (GND) gehalten wird und das zweite Steuersignal (V_{G}) auf dem zweiten Spannungspegel (V_{Gh}) gehalten wird.

## Claims

1. A memory cell comprising:
A microelectronic component comprising:
a semiconductor layer (21) resting on an insulating layer (23) resting on a silicon substrate (25) and comprising a doped source region (29) of a first conductivity type, a doped drain region (27) of a second conductivity type, and an intermediate region (31) non-doped or more lightly doped, with the second conductivity type, than the drain region (27), the intermediate region (31) comprising first (31A) and second (31B) portions respectively extending from the drain region (27) and from the source region (29); the first conductivity type and the second conductivity type being opposite;
an insulated front gate electrode (33) resting on said first portion (31A);
a first back gate electrode (37) arranged under the insulating layer (23), opposite the first portion (31A) and comprising a doped silicone region of the first conductivity type;
a second back gate electrode (39) arranged under the insulating layer (23), opposite the second portion (31B), and comprising a doped silicon region of the second conductivity type; and
control means adapted to supply a first bias voltage to the first back gate electrode (37), a second bias voltage, different from the first bias voltage, to the second back gate electrode (39), a reference voltage (GND) to the source region (29), a first control signal (V_{D}) to the drain region (27), and a second control signal (V_{G}) to the front gate electrode (33).

2. The memory cell of claim 1, wherein the semiconductor layer (21) is made of silicon.

3. The memory cell of claim 1 or 2, wherein the thickness of the semiconductor layer (21) is in the range from 5 to 30 nm, and the thickness of the insulating layer (23) is in the range from 5 to 30 nm.

4. A method of controlling the memory cell of claim 1, wherein:
for the writing of a '1' (W1), the first control signal (V_{D}) is set from the reference voltage (GND) to a first voltage level (V_{Dh}) for a first time interval (t1, t4), and the second control signal (V_{G}) is set from a second voltage level (V_{Gh}) to the reference voltage (GND) for a second time interval (t2, t3) included within the first interval;
for the writing of a '0' (W0), the second control signal (V_{G}) is set from the second voltage level (V_{Gh}) to the reference voltage (GND) for a third time interval (t7, t8); and
for a reading (R0, R1), the first control signal (V_{D}) is set from the reference voltage (GND) to the first voltage level (V_{Dh}) for a fourth time interval (t5, t6; t9, t10), the reference voltage (GND) being zero, the first voltage level (V_{Dh}) and the second voltage level (V_{Gh}) being greater in absolute value than the reference voltage (GND).

5. The control method of claim 4, wherein, for the writing of a '0' (W0), the first control signal (V_{D}) is maintained at the reference voltage (GND) and, for the reading (R0, R1), the second control signal (V_{G}) is maintained at the second voltage level (V_{Gh}).

6. The control method of claim 4or 5, wherein:
when the first conductivity type is type N, the first voltage level (V_{Dh}) and the second voltage level (V_{Gh}) are positive, the first bias voltage is positive or zero, and the second bias voltage is negative or zero; and
when the first conductivity type is type P, the first voltage level (V_{Dh}) and the second voltage level (V_{Gh}) are negative, the first bias voltage is negative or zero and the second bias voltage is positive or zero.

7. The control method of any of claims 4 to 6, wherein the first voltage level (V_{Dh}) and the second voltage level (V_{Gh}) are smaller than 1 V in absolute value.

8. The control method of any of claims 4 to 7, wherein, between two successive read (R1, R0) and/or write (W1, W0) operations, the first control signal (V_{D}) is maintained at the reference voltage (GND) and the second control signal (V_{G}) is maintained at the second voltage level (V_{Gh})
